(19) Europäisches Patentamt
European Patent Office
Office européen des brevets

(11) Publication number: **0 138 292**
**B1**

(12) **EUROPEAN PATENT SPECIFICATION**

(45) Date of publication of patent specification: **14.10.87**

(51) Int. Cl.$^4$: **C 30 B 15/10,** C 30 B 29/40

(21) Application number: **84304106.2**

(22) Date of filing: **18.06.84**

(54) **Apparatus for the growth of single crystals.**

(30) Priority: **06.08.83 JP 144149/83**
**06.08.83 JP 144150/83**

(43) Date of publication of application:
**24.04.85 Bulletin 85/17**

(45) Publication of the grant of the patent:
**14.10.87 Bulletin 87/42**

(84) Designated Contracting States:
**DE FR GB**

(56) References cited:
**FR-A-2 039 601**
**FR-A-2 193 656**
**GB-A-1 065 728**

**JOURNAL OF CRYSTAL GROWTH, vol. 19, no. 4, July 1973, pages 356-358, North-Holland Publishing Co.; P.C.LEUNG et al.: "Liquid-seal czochralski growth of gallium arsenide".**

(73) Proprietor: **SUMITOMO ELECTRIC INDUSTRIES LIMITED**
**No. 15, Kitahama 5-chome Higashi-ku**
**Osaka-shi Osaka 541 (JP)**

(72) Inventor: **Kotani, Tochihiro c/o Osaka Works**
**Sumitomo Electric Industries, Ltd**
**1-3, Shimaya 1-chome Konohana-ku Osaka (JP)**
Inventor: **Tada, Kohji c/o Osaka Works**
**Sumitomo Electric Industries, Ltd**
**1-3, Shimaya 1-chome Konohana-ku Osaka (JP)**

(74) Representative: **Horton, Andrew Robert Grant et al**
**BOULT, WADE & TENNANT 27 Furnival Street**
**London, EC4A 1PQ (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 138 292 B1

Courier Press, Leamington Spa, England.

**Description**

Background of the invention

1. Field of the invention

This invention relates to an apparatus for the growth of compound single crystals containing a component element having a high vapour pressure (which will hereinafter be referred to as "volatile element") by the Czochralsky method.

2. Description of the prior art

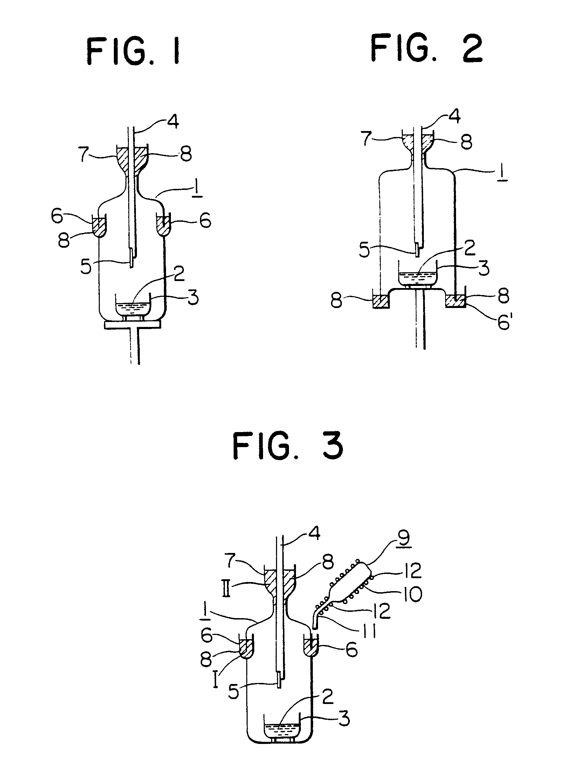

The hot wall method is known as a method for the Czochralsky growth of single crystals using a molten $B_2O_3$ seal ("Journal of Crystal Growth" *19* (1973) 356—358; "Journal of Crystal Growth" *24/25* (1974) 376/358; Japanese Patent Application OPI (Kokai) No. 123585/1979). In this method a sealed vessel 1 having a structure as shown in Figure 1 or Figure 2 is filled with a vapour of volatile element such as arsenic and pulling is carried out in sealed vessel 1. Sealed vessel 1 is provided inside with crucible 3 containing a raw material melt 2 and pull rod 4 for pulling upward with rotation, to the lower end of which seed crystal 5 is fitted. Referring to Figure 1, sealed vessel 1 is divided into an upper part and lower part at the side wall and provided with seals 6 and 7 at the opening part of the upper part and lower part and at the neck through which pull rod 4 passes. Referring to Figure 2, sealed vessel is divided at the bottom and provided with seals 6' and 7 at the opening part of the divided parts and at the neck through which pull rod 4 passes. In both the cases, the seals consist of $B_2O_3$ melt 8. Seed crystal 5 is immersed in raw material melt 2 and wetted therewith, and the crystal is grown and pulled up with revolving seed crystal 5.

These methods have a drawback that because of using a quartz vessel as sealed vessel 1, $B_2O_3$ melt 8 reacts with quartz and there is a large difference in coefficient of thermal expansion, resulting in breakage of the quartz vessel at the contact area with $B_2O_3$ melt. In addition, raw material melt 2 is contaminated with silicon from the quartz vessel according to the following reaction:

$$4Ga\text{ (in GaAs melt)}+SiO_2(s)\rightleftarrows 2Ga_2O(g)+Si\text{(in GaAs melt)}$$

thus resulting in Si contamination of the pulled single crystal and deterioration of the electrical properties.

When there is a difference in pressure between inside and outside sealed vessel 1 and pressure balancing is lost, the liquid surface of liquid seal 8 fluctuates. In an extreme case, liquid seal 8 itself falls from sealing portions 6 and 7, resulting in breakage and incompleteness of the sealing. That is, when seal 8, charged before pulling, falls from sealing portions 6 and 7 to break the seal, a volatile component element such as arsenic leaks and pulling is thus impossible. Consequently, it is necessary to charge again the raw materials for the single crystal and seal.

It is also known from GB—PS—1065728 to provide a sealed vessel for Czochralsky growth of a single crystal using an aluminium nitride or boron nitride crucible containing molten gallium, the atmosphere inside the sealed vessel being arsenic vapour. However, even in this proposal, the sealed vessel is made of quartz.

The present invention provides an apparatus for the Czochralsky growth of compound single crystals wherein a single crystal growing portion is provided in a sealed vessel whose opening part is sealed by a $B_2O_3$ melt and which contains therein an atmosphere of a volatile element of the compound, characterised in that at least the inner surface of the sealed vessel is made of a heat resistant material with a melting point of at least 1400°C selected from the group consisting of boron nitride and aluminiumnitride.

Brief description of the drawings

The accompanying drawings illustrate the principle and merits of the present invention in more detail.

Figure 1 to Figure 3 are schematic views of apparatus for the Czochralsky growth of single crystals according to the present invention.

Detailed description of the drawings

The present invention has been made so as to solve the above described problems and thus provides an apparatus for the growth of compound single crystals, free from breakage of the sealed vessel and contamination of pulled single crystal with silicon.

In the present invention, the compound single crystals include single crystals of compounds each containing a volatile component element, for example, III—V compounds such as GaAs, GaP, InAs and InP and II—VI compounds such as ZnS, ZnSe and CdS.

The heat resistant material of the sealed vessel is either boron nitride or aluminium nitride. The whole body of the sealed vessel need not always be made of the above described material, but at least the inner surface of the vessel should be of the above described material. In this case, for example, the vessel is made of a composite material consisting of an inner surface of the above described material and an outer surface of a material selected from quartz and graphite, or is made of quartz or graphite the inner surface of which is coated with the above described material.

The structures of the apparatus for the growth of single crystals according to one embodiment of the present invention are as shown in Figure 1 and Figure 2, but the present invention is not limited thereto. In the present invention, the sealed vessel 1 in Figure 1 or Figure 2 is made of pyrolytic boron nitride or aluminium nitride. Sealed vessel 1 is suitably divided as shown in Figure 1 or Figure 2 to facilitate the interior installation of the apparatus and the opening part and/or shaft part are provided with sealing portions 6, 6' and 7 and sealed by $B_2O_3$ melt 8 to seal

the vessel. A vapour of a volatile component element (e.g. As, P) of the compound is provided in vessel 1 while holding similar the pressure of the atmosphere (Ar or $N_2$) outside vessel 1, and a single crystal is pulled by the Czochralsky method.

Since boron nitride and aluminium nitride contain no Si and are very stable chemically to $B_2O_3$ melt even at a high temperature, no reaction with $B_2O_3$ melt takes place as in a quartz vessel of the prior art, a vessel of pyrolytic boron nitride (PBN) or BN is not broken and contamination of a pulled single crystal with Si can be prevented.

In another embodiment of the present invention, a means for supplementing or filling up a liquid seal is provided to maintain the seal even if the liquid seal falls due to pressure unbalance inside and outside the vessel, whereby means for holding the sealing liquid can be minimised and the vessel can be made compact.

This embodiment will be illustrated in detail by the accompanying drawings. Figure 3 is a vertical cross-sectional view of the embodiment of the apparatus according to the present invention, in which the same numerals as those of Figure 1 denote the same portions. The difference of Figure 3 from Figure 1 is that means 9 for supplementing a liquid seal such as $B_2O_3$ melt to sealing portions 6 and 7 are provided. The rest of the structure is completely the same as that of Figure 1. Of course, the present invention is not limited to the structure of Figure 3, but can be adapted for any apparatus for the growth of single crystals by the hot wall method, provided with a liquid sealing portion.

As shown in Figure 3, for example, sealant supplying means 9 consists of a supplying vessel 10 fitted at one end with tube 11, round which heater wire 12 is wound. Supplying vessel 10 is previously charged with a liquid sealant raw material such as $B_2O_3$ and when sealing portion 6 or 7 is lacking in liquid seal 8, electric current is applied to heater wire 12 to melt the sealant such as $B_2O_3$ and the liquid sealant is added to sealing portion 6 or 7 from tube 11. In this case, confirmation of liquid seal 8 in sealing portions 6 and 7 is ordinarily carried out by an eye window using a quartz rod or by an electric detection method using change of electric capacity or electric resistance.

When using $B_2O_3$ melt as liquid seal 8, the material of supplying vessel 10 is preferably molybdenum, PBN, BN, AlN or $Al_2O_3$ which makes reuse possible. Sealant supplying vessel 10 can be provided for common use or one by one to sealing portions 6 and 7, and can be provided outside an outer chamber with a shutter for feeding a sealant.

When such a sealant supplying means 9 is provided, sealing of vessel 1 can always be maintained by supplying the sealant even if liquid sealant 8 falls from sealing portions 6 and 7, resulting in shortage thereof, due to pressure unbalance inside and outside vessel 1 during pulling a single crystal. Accordingly, leakage of a vapour of a volatile element such as As in vessel 1 can be prevented thus decreasing markedly the loss thereof and making possible pulling of a single crystal for a long time.

The above described apparatus for the growth of compound single crystals according to the present invention has the following advantages:

(a) Since the sealed vessel is made of boron nitride or aluminium nitride, which are very stable chemically to $B_2O_3$ melt even at a high temperature and have a higher mechanical strength than quartz even at a high temperature, repeated use of the vessel is possible without danger of any damage or breakage.

(b) Since boron nitride and aluminium nitride can be prepared with a high purity, for example, with an overall impurity quantity of about 100 ppm, and do not contain silicon, contamination of a pulled single crystal with impurities such as Si can be prevented and thus a single crystal free from contamination by silicon can be obtained in effective manner.

(c) Since boron nitride and aluminium nitride have a higher work accuracy than quartz used in the prior art, the dimensional accuracy of the vessel, in particular, at the sealing portion of the shaft part important for sealing is increased and the clearance between the vessel and shaft can be decreased, thus resulting in that $B_2O_3$ melt in the sealing portion can be prevented from falling.

(d) Since a sealant supplying means is provided for supplementing the sealing portion of a vessel with a liquid sealant, i.e. $B_2O_3$ melt, sealing of the vessel can always be maintained and accordingly leakage of a vapour of the atmosphere in the vessel can be prevented, thus decreasing markedly the loss thereof and making possible pulling of a single crystal for a long period of time.

(e) Since the sealant holding portion can be filled initially with a liquid seal or can suitably be supplemented therewith by provision of the sealant supplying means, the sealant holding portion does not need an excessive volume for accommodating an increased volume of solid raw material. Thus the sealed vessel can be made compact.

Example 1

GaAs single crystal was grown by the Czochralsky method using an apparatus for the growth of single crystals, as shown in Figure 1, comprising sealed vessel 1 made of BN with an outer diameter of 120 mm and a length of 700 mm.

In sealed vessel 1 was set a PBN crucible 3 charged with 1 kg of GaAs polycrystal, and was charged with 20 g of metallic As for feeding As vapour. For pull rod 4 there was used a molybdenum rod not attacked by $B_2O_3$ melt and As vapour. After the melting of GaAs at a temperature of 1260°C, a single crystal was drawn at a rate of 5 mm/hr with a gradual lowering of the temperature (0.03—0.05°C/min).

The thus resulting GaAs single crystal had a diameter of 5.08 cm (2") and length of about 60 mm, an Si content of less than $1\times10^{15}$ $cm^{-3}$ by

SIMS analysis and a semi-insulating property of a specific resistance of $5\times10^7$ ohm cm (undoped).

On the other hand, another GaAs single crystal obtained by repeating the above described procedure except using a quartz vessel of the prior art as sealed vessel 1 had a higher Si content, i.e. $6\times10^{16}$ $cm^{-3}$ and a lowered specific resistance.

The BN vessel used herein was hardly damaged and was capable of being used about 15 times. In the quartz vessel of the prior art, it was difficult to hold the clearance at the rod part less than 0.1 mm and falling of $B_2O_3$ melt took place during pulling, while in the BN vessel of the present invention, it was possible to hold the rod clearance less than 0.05 mm and to prevent substantially $B_2O_3$ from falling.

Example 2

GaAs single crystal was grown by the Czochralsky method using an apparatus for the growth of single crystals, as shown in Figure 1, comprising a sealed vessel 1 made of AlN with an outer diameter of 120 mm and a length of 700 mm.

In sealed vessel 1 was set PBN crucible 3 charged with 1.2 kg of GaAs polycrystal, and was charged with 50 g of metallic As for feeding As vapour. For pull rod 4 there was used a molybdenum rod not attacked by $B_2O_3$ melt and As vapour. As vapour at a pressure of about $10^5$ Pa (1 atm) was held inside the vessel and nitrogen gas at a pressure of about $10^5$ Pa (1 atm) was held outside the vessel. After melting the GaAs polycrystal at a temperature of 1260°C, a single crystal was drawn at a rate of 5 mm/hr with lowering gradually the temperature of the crucible. The diameter of the single crystal, during seeding and pulling, was controlled by measurement of the weight of the crystal.

The resulting GaAs single crystal had a diameter of 5.08 cm (2″), a length of about 75 mm and a good semi-insulating property, i.e. specific resistivity of from front to tail of $2\times10^7$ ohm cm (undoped). SIMS analysis showed an Si content of less than $1\times10^{15}$ $cm^{-3}$ and an Al content of $2\times10^{15}$ $cm^{-3}$.

The vessel of AlN used in this example could be used repeatedly 10 times without any breakage.

Example 3

GaAs compound semiconductor single crystal was grown using an apparatus for the growth of single crystals, as shown in Figure 3, comprising a sealed vessel 1 made of PBN with an outer diameter of 90 mm and a length of 350 mm.

Using $B_2O_3$ melt as liquid sealant 8, an atmosphere of As vapour under a pressure of about $10^5$ Pa (1 atm) was held in sealed vessel. $B_2O_3$ melt holding portion I at sealing portion 6 had a volume of 47 $cm^3$ in which 40 g of $B_2O_3$ was charged and $B_2O_3$ melt holding portion II at sealing portion 7 had a volume of 50 $cm^3$ in which 50 g of $B_2O_3$ was charged. Since the density of $B_2O_3$ is about 1.7 g/$cm^3$ at room temperature, the required volume of holding portions I and II are originally 24 $cm^3$ and 29 $cm^3$. Thus, volumes of 1.7 to 2 times as large as originally required was actually used to charge the above described amounts of $B_2O_3$.

When using the above described growth apparatus having no sealant supplying means 9, about 10 g of $B_2O_3$ was lost at $B_2O_3$ melt holding portion I and about 20—25 g of $B_2O_3$ was lost at holding portion II. Particularly, at sealing portion 7, $B_2O_3$ melt tends to fall from holding portion II due to pressure unbalancing, resulting in large loss thereof and leakage of As vapour.

On the other hand, sealant supplementing means 9 consisting of supplying cylindrical vessel 10 with a diameter of 50 mm and a length of 60 mm, made of molybdenum and fitted at one end with tube 11, round which heater wire 12 of Kanthal was wound, was provided at sealing portion 6. A power of about 800 W was applied to the heater.

About 100 g of $B_2O_3$ was charged in cylindrical vessel 10 and supply of $B_2O_3$ to sealing portion 6 was carried out by ON-OFF control of electric current to heater wire 12. By the provision of sealant supplementing means 9, $B_2O_3$ melt fallen and lost at sealing portion 6 could be supplemented and the volume of $B_2O_3$ melt holding portion I could be reduced from 47 $cm^3$ to 35 $cm^3$, thus making vessel 1 compact.

**Claims**

1. Apparatus for the Czochralsky growth of compound single crystals wherein a single crystal growing portion is provided in a sealed vessel whose opening part is sealed by a $B_2O_3$ melt and which contains therein an atmosphere of a volatile element of the compound, characterised in that at least the inner surface of the sealed vessel is made of a heat resistant material with a melting point of at least 1400°C selected from the group consisting of boron nitride and aluminium nitride.

2. Apparatus according to Claim 1, further comprising supply means for supplementing the $B_2O_3$ melt.

3. Apparatus of Claim 2, wherein the supply means has a supplying vessel which is made of molybdenum, pyrolytic boron nitride, boron nitride, aluminium nitride or alumina.

4. Apparatus according to Claim 3, wherein the supplying vessel is fitted at one end with a tube, round which a heater wire is wound.

**Patentansprüche**

1. Vorrichtung für die Czochralsky-Züchtung von Einkristallen aus einer Verbindung, wobei ein Einkristall-Züchtungsabschnitt in einem abgedichteten Behälter vorgesehen ist, dessen Öffnungsteil durch eine $B_2O_3$-Schmelze abgedichtet ist und der eine Atmosphäre aus einem flüchtigen Element der Verbindung enthält, dadurch gekennzeichnet, daß wenigstens die Innenfläche des abgedichteten Behälters aus einem hitzebeständigen Material mit einem Schmelzpunkt von wenigstens 1400°C hergestellt ist, wobei das Material

aus der Gruppe ausgewählt wird, die aus Bornitrid und Aluminiumnitrid besteht.

2. Vorrichtung nach Anspruch 1, welche weiterhin Zuführungseinrichtungen zum Ergänzen der $B_2O_3$-Schmelze aufweist.

3. Vorrichtung nach Anspruch 2, wobei die Zuführungseinrichtung einen Speisebehälter hat, der aus Molybdän, pyrolytischem Bornitrid, Bornitrid, Aluminiumnitrid oder Tonerde hergestellt ist.

4. Vorrichtung nach Anspruch 3, bei welcher der Speisebehälter an einem Ende mit einem Rohr versehen ist, um das ein Heizdraht gewickelt ist.

**Revendications**

1. Appareil pour la croissance de Czochralsky de monocristaux composés où une portion de croissance d'un monocristal est prévue dans un récipient scellé dont la partie d'ouverture est scellée par un $B_2O_3$ fondu et qui contient une atmosphère d'un élément volatil du composé, caractérisé en ce qu'au moins la surface interne du récipient scellé est faite en un matériau thermo-résistant ayant un point de fusion d'au moins 1400°C, choisi dans le groupe consistant en nitrure de bore et nitrure d'aluminium.

2. Appareil selon la revendication 1, comprenant de plus un moyen d'alimentation pour compléter $B_2O_3$ fondu.

3. Appareil selon la revendication 2 où le moyen d'alimentation a un récipient d'alimentation qui est fait en molybdène, nitrure de bore pyrolytique, nitrure de bore, nitrure d'aluminium ou alumine.

4. Appareil selon la revendication 3 où le récipient d'alimentation est pourvu à une extrémité d'un tube, autour duquel est enroulé un fil métallique réchauffeur.

FIG. 1

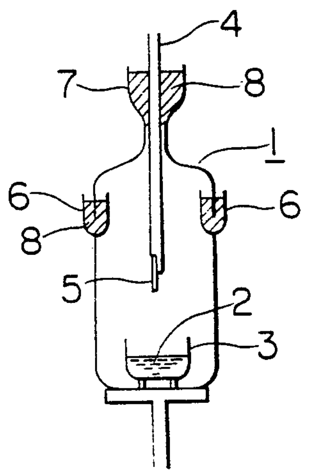


FIG. 2

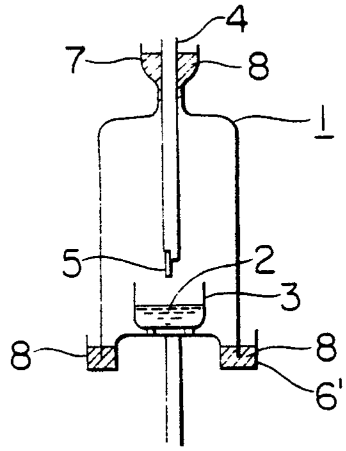


FIG. 3